Europäisches Patentamt

European Patent Office

Office européen des brevets

(11) Publication number: **0 437 893 A1**

# EUROPEAN PATENT APPLICATION

(21) Application number: 90203525.2

(51) Int. Cl.5: **G01C 17/28**

(22) Date of filing: **31.12.90**

(30) Priority: **08.01.90 NL 9000045**

(43) Date of publication of application:
**24.07.91 Bulletin 91/30**

(84) Designated Contracting States:
**FR GB IT NL**

(71) Applicant: **IVE ELECTRONICS**
**Postbus 189**
**NL-7550 AD Hengelo(NL)**

(72) Inventor: **Yff, Louis S.**
**Postbus 189**
**NL-7550 AD Hengelo(NL)**

(74) Representative: **Jansen, Cornelis Marinus**
**Middelvaart 46**
**NL-4285 WS Woudrichem(NL)**

(54) **Electric compass.**

(57) The electric compass provided with a coil, rotating means for rotating the coil, a control unit connected to the coil which generates a direction signal representing the direction of the earth's magnetic field with the aid of an induction voltage generated by the coil, characterized in that, the rotating means are provided with a clock pulse generator and a stepping motor controlled by the clock pulse generator, where the control unit is supplied with a control signal comprising information about the position of the coil relative to a reference direction.

FIG. 1

## ELECTRIC COMPASS

The invention relates to an electric compass provided with a coil, rotational means for rotating the coil, and a control unit connected to the coil which generates a direction signal representing the direction of the earth's magnetic field with the aid of an induction voltage generated by the coil. It is generally known that the rotational means of such a compass can be provided with a conventional electro-motor which is linked to a highly advanced servomechanism. This is necessary in order to achieve the required accuracy of e.g. +/- 1.5 degrees. The idea is to make the coil rotate with a definite angular velocity of Ω. As a result of the interaction with the earth's magnetic field, a sinusoidal induction voltage is realized. This induction voltage is analyzed by the control unit to determine the momentaneous direction of the earth's magnetic field in relation to the coil. As the momentaneous direction of the coil in relation to the compass is known with the help of the servomechanism, i.e. in relation to a reference direction coupled with the housing of the compass, the control unit can determine the momentaneous direction of the reference direction in relation to the earth's magnetic field together with information about the momentaneous orientation of the coil in relation to the earth's magnetic field. This orientation can be illustrated with the help of a display for instance.

Such a compass has however the disadvantage, viz. it is not accurate enough for modern applications and due to the advanced servo mechanism which has been used, it is very expensive. The aim of the invention is to provide a compass of great accuracy that can be produced at low cost. According to the invention the rotational means are provided with a clock pulse generator and a stepping motor controlled by the clock pulse generator where the control unit is supplied with a control signal which contains information about the position of the coil relative to the reference direction.

By combining a clock pulse generator with a stepping motor, it is possible to realize an extremely accurate compass which is inexpensive at the same time. This is due to the fact that the advanced servo mechanism is left out. The step size of a stepping motor can be chosen as e.g. 0.5 degrees, so that an accuracy of 0.25 degrees can be achieved. The control signal has a special feature viz. it consists of the clock signal fed to the stepping motor and of a trigger signal which marks at least one moment when the coil takes up a predetermined position in relation to the housing. Thus the control signal contains information about the momentaneous orientation of the coil with respect to the position of the reference direction.

As a result of the application of a clock pulse generator in combination with a stepping motor, according to a special embodiment of the invention the control unit can be provided with a counter which is reset at zero with the trigger signal when the coil has taken up predetermined position with respect to the housing of compass and which is clocked by means of the clock signal, a memory unit and a detection unit to which the induction voltage is fed generated with the aid of the coil and which induces control pulse at the moment when the induction voltage passes positive or a negative zero crossing where the control directs the memory unit such that it reads the content of the counter. Owing to the fact that the signals generated in the control unit are in digital form, there is the additional advantage that the compass can be directly connected to a computer. This could be a computer on board a ship which is thus continually informed of the momentaneous course of the ship so that this can be registered, analyzed and if necessary corrected.

The invention will be explained in detail with the help of the following diagrams:

diagram 1: this represents a possible design of the invention;

diagram 2: this shows a vector diagram to illustrate how the compass works;

diagram 3: this shows how the control unit in diagram 1 could be constructed;

diagram 4: this represents the possible form of the induction voltage generated by the coil in diagram 1 ;

diagram 5: this shows an alternative way to construct the control unit in diagram 1.

A clock pulse generator 1 of diagram 1 sends clock pulses via wire 2 to a stepping motor 3. The clock pulse frequency is equal to $f_s$. The value of $f_s$ is for instance equal to 1080 Hz. The stepping motor 3 is rotating when it receives a clock pulse at an angle of $\Delta\alpha_s = \frac{1}{2}.2\pi/360$ rad. Stepping motor 3 rotates via a drive shaft 4 coil 5 which should preferably be mounted vertically. The coil rotates with a angular velocity of Ω according to the formula:

$$\Omega = (\Delta\alpha/\Delta t) = \Delta\alpha_s.f_s \quad (1)$$

From formula (1) can be concluded that in this case $\Omega = 3\pi$ rad/s. The induction voltage generated by coil 5 will be:

$$V_{ind} = -N(d\Phi/dt) = -N(d(\overline{A}.\overline{B})/dt) \quad (2)$$

whereby $\Phi$ indicates the magnetic flux through the coil surface, $\overline{A}$ the size and direction of the coil surface, $\overline{B}$ the size and direction of the earth's magnetic field and N the number of coil windings. The point in formula 2 represents an inner vector multiplication. For the inner vector multiplication we write:

$$\overline{A}.\overline{B} = A.B.\cos\alpha \quad (3)$$

in which A and B respectively indicate the size of the surface and the amplitude of the earth's magnetic field and $\alpha$ the angle between the normal vector to the coil area and the earth's magnetic field. For angle $\alpha$ we write due to the rotation of the coil

$$\alpha = \alpha_o + \Omega.t = \alpha_o + \Delta\alpha_s.f_s.t \quad (4)$$

Here $\alpha_o$ indicates an angle between the normal vector on the coil surface and the direction of the earth's magnetic field at point of time $t = 0$. When combining formulas (2),(3) and (4) we get:

Vind
$= -N.A.B (d\cos\alpha/dt)$
$= -N.A.B (d\cos(\alpha_o + \alpha_s.f_s.t)/dt)$
$= N.A.B.\Delta\alpha_s.f_s.\sin(\alpha_o + \Delta\alpha_s.f_s.t) \quad (5)$

In other words:

$$V_{ind} = N.A.B.\Delta\alpha_s.f_s.\sin\alpha \quad (6)$$

in which $N,A,B,\Delta\alpha_s$ and $f_s$ are constants.
The induction voltage $V_{ind}$ is led to a control unit 7 via wire 6. Furthermore the control unit is supplied with a control signal via wire 8 which indicates the momentaneous position $\alpha'$ of the normal vector 12 of coil 5 in respect of a reference direction 11 coupled to the housing of the compass (see diagram 2) For this purpose control unit 7 is provided with means which will be described below in order to determine the moment when $\alpha_o = 0$, i.e. when the normal vector 12 on the coil area points into the direction of the earth's magnetic field. Then the value $\alpha'$ i.e. the momentaneous direction of reference direction 11 in respect of coil 5 is also known on the basis of information on line 6. Now direction $\alpha''$ of reference direction 11 of the housing with respect to direction 14 of the earth's magnetic field is also known, as this is equal to the direction of reference direction 11 in respect of direction 14 of the earth's magnetic field. Diagram 3 shows a possible embodiment for control unit 7. The control signal on line 8 comprises the clock signal of the clock pulse generator 1. Besides line 8 includes a trigger signal indicating when coil 5 takes up a predetermined position in respect of the housing of the compass. For this purpose the compass includes an optical sensor 13 linked to the housing. The optical sensor 13 detects the passing of a black dote on the coil assembly. The moment the dot passes the optical sensor, a trigger pulse is generated. The trigger signal resets a digital counter 15 to zero when the coil takes up the direction mentioned above. Next the counter adds 1 at every clock pulse. This implies that the digital value of counter 15 represents the position of coil 5 in relation to reference direction 11 at all times. It will be clear that:

$$\alpha_s = \tfrac{1}{2}.2\pi.n/360 \quad (7)$$

in which n represents the value of the content of counter 15. Here is $0 \leq \alpha_s \leq 2\pi$ so that $0 \leq n \leq 719$. Via line 16 the digital value of the content of the counter is offered to memory unit 17. As $0 \leq n \leq 719$ memory unit 17 includes a 10 bit register so that the memory can contain at least the maximum number to be viz. registered 719. Memory 17 takes over the content of counter 15 at the moment when the normal vector 15 takes up direction 14 of the earth's magnetic field. For this the induction voltage V is fed via line 6 to a preamplifier 18 which has an amplification of 100 in this case. Signal S which has thus been amplified and the shape of which is shown in diagram 4, is led to a zero-crossing detector 19. Detector 19 is a generally well-known type which detects zero crossings P that are going positive (see diagram 4) The moment when detector 19 detects the zero crossing P, the normal vector of the coil points to the North (the direction of the earth's magnetic field) and the content of the counter is written in memory 17. The content of memory 17 is then an indication for the direction of reference 11 with respect to direction 14 of the earth's magnetic field. Through line 20 the content of memory 17 is fed to a decoder 21. Then decoder 21 generates a signal based on the content of memory 17 which is led to display 10 through line 9 so as to show the content of counter 15. This can be done in either radians (see formula 7) or in degrees. It is simple to show $\alpha''$ in degrees as 1 bit corresponds with 0.5 degrees. Decoder 21 can be supplied with a dividing-two unit to obtain a binary value of $\alpha''$ expressed in degrees. This binary code can then be shown on display 10 with in themselves well known means. It is also possible to show the content of memory 17 in graphics, again by means of well known techniques. Via line 22, the signal fed to the decoder is also fed to connector 23 which can be connected to a computer. This could be done on board a ship e.g. using an electric compass as described above.

With the help of a computer the course can be registered as a function of time. With additional information such as the speed of the ship the route which has been covered can be calculated and registered. If necessary course corrections could be executed automatically. Diagram 5 shows an alternative version of the control unit.

Those parts corresponding with parts in diagram 4 have been given identical reference numbers. Via the signals on line 8 the counter is reset at zero and clocked at the speed of clock pulse generator 1, just as has been described above.

Here too the content of the counter indicates the direction of normal vector 12 of coil 5 in respect of reference direction 11. The signal generated by zero-crossing detector 19, is fed to counter 15 and this achieves that the then valid digital content is fed to decoder 21 via line 16. This content represents the direction of the earth's magnetic field with respect to reference direction 11 as was mentioned above. The decoder functions in this as described in diagram 3.

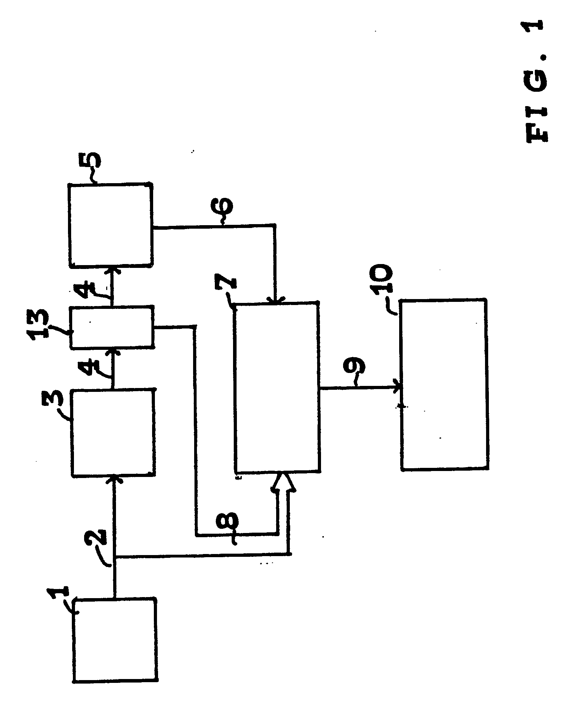

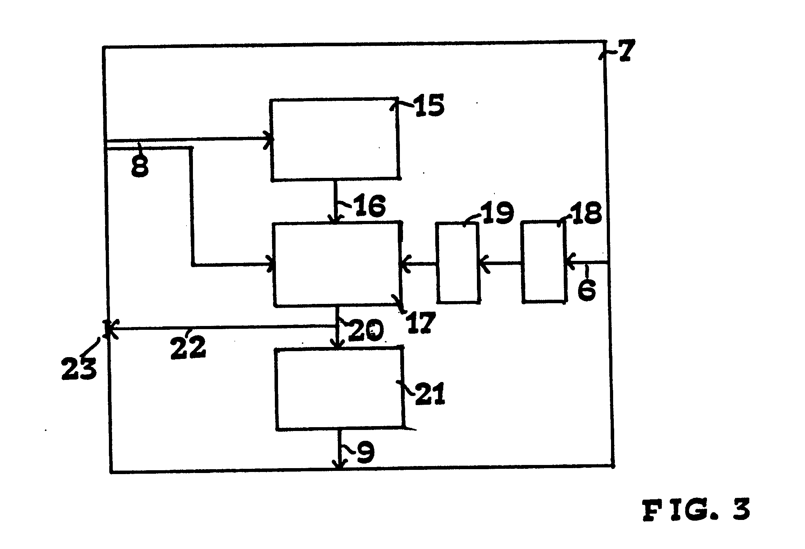

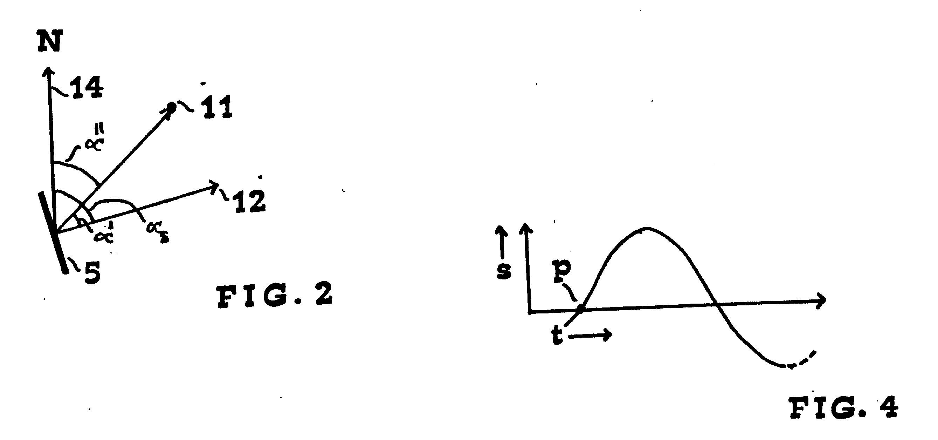

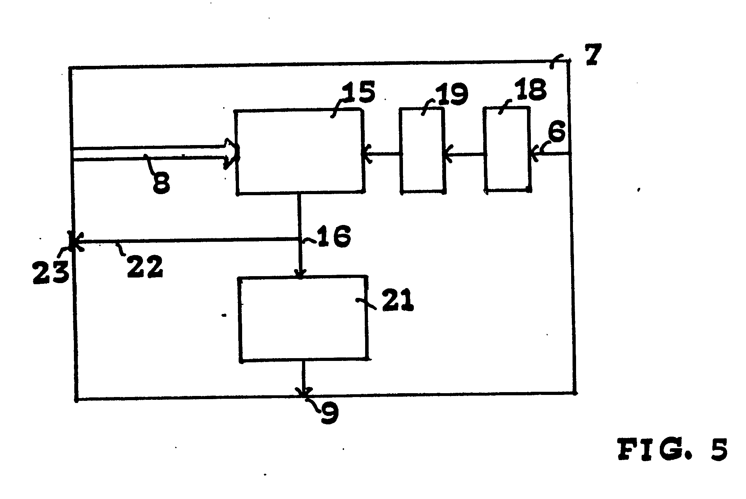

## Claims

1. An electric compass provided with a coil, rotating means for rotating the coil, a control unit connected to the coil which generates a direction signal representing the direction of the earth's magnetic field with the aid of an induction voltage generated by the coil, characterized in that, the rotating means are provided with a clock pulse generator and a stepping motor controlled by the clock pulse generator, where the control unit is supplied with a control signal comprising information about the position of the coil relative to a reference direction.

2. An electric compass according to claim 1, characterized in that, that the control signal includes the clock signal fed to the stepping motor.

3. An electric compass according to claim 2, characterized in that, the control signal includes a trigger signal that at least marks the moment when the coil takes up a predetermined position with respect to the housing of the compass whereby the reference direction is coupled to the housing of the compass.

4. An electric compass according to claim 3, characterized in that, the control unit is provided with a counter which is reset at zero with the trigger signal when the coil has taken up the predetermined position with respect to the housing of the compass and which is clocked by means of the clock signal, a memory unit and a detection unit to which the induction voltage is fed generated with the aid of the coil and which induces a control pulse at the moment when the induction voltage passes a positive or a negative zero crossing where the control pulse directs the memory unit such that it reads the momentaneous content of the counter.

5. An electric compass according to claim 4, characterized in that the control unit is provided with a decoder which is linked to the memory unit, which decoder converts the content of the memory unit to the direction signal which is suitable for controlling a display.

6. An electric compass according to claim 3, characterized in that, the control unit is provided with a counter which is reset at zero by the trigger signal when the coil has taken up the predetermined position with respect to the housing of the compass and which is clocked with the clock signal.

7. An electric compass according to claim 5, characterized in that, the control unit is provided with a decoder linked to the counter, which converts the content of the counter to the direction signal suitable for a display on the moment that it is stopped by the stop pulse.

8. An electric compass according to claim 4 or 5, characterized in that, the detection unit is supplied with a pre-amplifier of which the input has been connected to the coil and a zero-crossing detector connected to an output of the pre-amplifier where the zero-crossing detector generates the control pulse.

9. An electric compass according to claim 5 or 7, characterized in that, the compass is provided with a display to show in degrees the direction of the earth's magnetic field relative to the reference direction.

10. An electric compass according to claim 5 or 7, characterized in that, the compass is provided with a connector for supplying to a computer the input signal of the decoder.

FIG. 1

EP 0 437 893 A1

FIG. 3

EP 0 437 893 A1

**N**

14

11

$\alpha''$

12

$\alpha'$

$\alpha_s$

5

# FIG. 2

s

p

t →

# FIG. 4

FIG. 5

European
Patent Office

**EUROPEAN SEARCH
REPORT**

Application Number

**EP 90 20 3525**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | GB-A-2 090 662 (ROBOPHONE) <br> * Page 1, line 88 - page 2, line 40; figures 1-4 * <br> – – – | 1 | G 01 C <br> 17/28 |
| A | US-A-3 397 358 (ALLENDEN et al.) <br> * Whole document * <br> – – – | 1 | |
| A | US-A-4 139 951 (CUNARD et al.) <br> * Figure 7; claim 1 * <br> – – – | 1 | |
| A | PATENT ABSTRACTS OF JAPAN, vol. 6, no. 51 (P-108)[929], 6th April 1982; <br> & JP-A-56 166 409 (MATSUSHITA DENKI SANGYO K.K.) 21-12-1981 <br> * Whole document * <br> – – – – – | 1 | |

| | TECHNICAL FIELDS SEARCHED (Int. Cl.5) |
|---|---|
| | G 01 C |

The present search report has been drawn up for all claims

| Place of search | Date of completion of search | Examiner |
|---|---|---|
| The Hague | 18 April 91 | KOLBE W.H. |

CATEGORY OF CITED DOCUMENTS

X : particularly relevant if taken alone
Y : particularly relevant if combined with another
     document of the same catagory
A : technological background
O : non-written disclosure
P : intermediate document
T : theory or principle underlying the invention

E : earlier patent document, but published on, or after
     the filing date
D : document cited in the application
L : document cited for other reasons
........................................................................................
& : member of the same patent family, corresponding
     document